# Europäisches Patentamt
# European Patent Office
# Office européen des brevets

(19)

(11) Publication number: **0 245 510**

A1

(12)

# EUROPEAN PATENT APPLICATION
published in accordance with Art. 158(3) EPC

(21) Application number: 86906457.6

(22) Date of filing: 31.10.86

Data of the international application taken as a basis:

(86) International application number:
PCT/JP86/00556

(87) International publication number:
WO87/02718 (07.05.87 87/10)

(51) Int. Cl.³: **C 30 B 15/02**
**C 30 B 29/06**

(30) Priority: 01.11.85 JP 244116/85
13.03.86 JP 53560/86
05.06.86 JP 129192/86

(43) Date of publication of application:
19.11.87 Bulletin 87/47

(84) Designated Contracting States:
DE FR GB IT NL

(71) Applicant: NIPPON KOKAN KABUSHIKI KAISHA
1-2 Marunouchi 1-chome Chiyoda-ku
Tokyo 100(JP)

(72) Inventor: KAMIO, Hiroshi
8-4, Kouyama 3-chome
Nerima-ku Tokyo 176(JP)

(72) Inventor: NAKAOKA, Kazuhide
534-2, Higashihongocho Midori-ku
Yokohama-shi Kanagawa 226(JP)

(72) Inventor: ARAKI, Kenji
2238-34, Kamariyacho Kanazawa-ku
Yokohama-shi Kanagawa 236(JP)

(72) Inventor: MURAKAMI, Katsuhiko
30-18, Yokodai 1-chome Isogo-ku
Yokohama-shi Kanagawa 235(JP)

(72) Inventor: KAZAMA, Akira
24-14, Nishikubo 2-chome
Musashino-shi Tokyo 180(JP)

(72) Inventor: HORIE, Shigetake
18-12, Nishikamata 5-chome
Ota-ku Tokyo 144(JP)

(74) Representative: Marsh, Roy David et al,
Michael Burnside & Partners 2, Serjeants' Inn Fleet Street
London EC4Y 1HL(GB)

(54) APPARATUS FOR PRODUCING SEMICONDUCTOR SINGLE CRYSTAL.

(57) An apparatus for continuously producing a semiconductor single crystal which can control the temperature of a semiconductor solution in a crucible to the optimum temperature and the feed of a starting material to the optimum quantity. In a semiconductor single crystal production apparatus which pulls up little by little the semiconductor material from a molten bath of the semiconductor material melted in the crucible and solidifies the material in a cylindrical form to obtain the semiconductor single crystal, the apparatus of the present invention includes therein at least one starting material bar of the semiconductor material and a high-frequency induction heating coil for heating and melting the starting material bar.

SPECIFICATION

# APPARATUS FOR PRODUCING SEMICONDUCTOR SINGLE CRYSTAL

Technical Field

The present invention relates to an apparatus for manufacturing semiconductor single crystals and more particularly to an apparatus for continuously manufacturing high-quality semiconductor single crystals which are excellent in homogeneity.

Background Art

Recently, due to an increasing demand for single crystals of a semiconductor such as silicon and for the purpose of enhancing the productivity of device makers, there has been a trend toward increasing the size of apparatus for the manufacturing of semiconductor single crystals and toward rapid increase in the diameter of semiconductor single crystals.

In a batch type semiconductor single crystal manufacturing apparatus due to its characteristics, the amount of melt in a molten pool of a semiconductor is decreased as a semiconductor single crystal is pulled from the molten pool and grows as it is pulled. Thus, the concentration of the doping agent in the molten pool is increased and the segregation of the doping agent in the pulled and grown semiconductor single crystal is gradually increased in the longitudinal direction. In other words, there is a disadvantage that the characteristics of the manufactured semiconductor single crystal vary along the longitudinal direction.

In other words, due to the segregation of the doping agent, the electrical resistivity of the semiconductor single crystal is decreased gradually as the solidification proceeds. In the case of C-MOS devices requiring the most severe specifications, for example, the yield of wafers which meet the specifications is less than about 40 % of the length of a grown semiconductor single crystal. The continuous feeding of a starting material is effective for solving this problem. However, the present situation is such that this has not been put in practice as yet.

The prior art for continuous feeding methods include the following. For example, Japanese Patent Application Laid-Open No. 52-58080, No. 56-164097, No. 56-84397 and No. 59-79000 have proposed methods in which a starting material comprising a semiconductor material is fed continuously into a molten pool so as to prevent any variation in quality accompanying the growth of a semiconductor single crystal.

In this way, the continuous feeding of a semiconductor starting material is effective in preventing the variation in quality along the longitudinal direction of a semiconductor single crystal. Even with such continuous feeding, however, it is an essential requirement for the production of a homogeneous semiconductor single crystal that the proper temperature control and feed rate control (melt surface level control) of a feed starting material are effected satisfactorily.

The method of Japanese Patent Application Laid-Open No. 52-58080 requiring a semiconductor starting material melting crucible and another crucible for pulling purposes is much complicated structurally and gives rise to considerable difficulties from the standpoint of the proper temperature control in the runner tube connecting the two crucibles and the control of very small feed flow rates.

Japanese Patent Applciation Laid-Open No. 56-164097 discloses a method in which a semiconductor starting material in powder form is intermittently received for temporary storage purposes from the outside of a single crystal manufacturing apparatus into a small melting crucible set inside the apparatus and the material is fed, as it is melted, into the molten pool. As in the case of the above-mentioned method, this method also requires the melting crucible and the apparatus is complicated. In addition, the semiconductor starting material supplied is heated indirectly and therefore it is difficult to accurately control the temperature of the molten material fed into the molten pool. However, the intermittent feeding unavoidably causes variations in the feed rate of the molten material. In addition, it is impossible to solve the essential problem of the entry of impurities during the production stage of powdered starting material.

The method of Japanese Patent Application Laid-Open No. 56-84397 has no axial synmetry of the apparatus, with the result that the crucible cannot be rotated and it is difficult to produce a homogeneous semiconductor single crystal from the temperature point of view and the standpoint of uniformity of the doping agent concentration.

On the other hand, Japanese Patent Application Laid-Open No. 59-79000 employs only the heater of a crucible as a heat source for melting a starting material and therefore the heater temperature must be considerably higher than the heater temperature in the batch method. As a result, the radial temperature gradient within the crucible is increased and the uniformity of the temperature within the crystal growth interface is deteriorated. As a result, nonuniformity is caused in the radial crystal growth rate thereby making it difficult to maintain uniformity of the quality in the radial direction. Also, the growth rate of the crystal is decreased very greatly.

In spite of a number of proposals which have been made concerning the continuous pulling as mentioned above, these proposals have involved many difficulties and they have not been put in practice as yet.

The present invention is capable of properly controling the temperature and feed rate (melt surface level) of a feed starting material. In other words, it is an object of the invention to provide a semiconductor single crystal manufacturin apparatus capable of continuously manufacturing semiconductor single crystals having a uniform electrical resistivity in both the radial and lengthwise direction.

Disclosure of Invention

A semiconductor single crystal manufacturing apparatus according to the invention is of the type in which from a molten pool of a semiconductor material melted into a crucible the semiconductor material is gradually pulled and solidified into a round shape bar while rotating it thereby obtaining a semiconductor single crystal and the apparatus includes therein at least one long piece of semiconductor starting material, and high-frequency induction heater means for heating and melting the starting material piece.

In accordance with the invention, the temperature of a semiconductor starting material to be fed into a molten pool can be naturally and accurately controlled at the optimum temperature just above the melting point of the material and the starting material can be stably and continuously dripped in an amount corresponding to the amount of solidification pulled as a semiconductor single crystal.

It is apparent in the light of its principle that in accordance with the invention a highly accurate temperature control is performed automatically. The reason is that although it is a matter of course, when the starting material piece attains a temperature just above its melting point of the most desirable temperature for the growth of a semiconductor single crystal, the melting of the starting material piece is initiated and simultaneously with this melting the melted material is dripped into the molten pool of the semiconductor material.

By virtue of this fact, it is possible to ensure a uniform crystal growth rate without disturbing the temperature distribution in the semiconductor crystal interface. In addition, the feed rate of the starting material can be controlled easily with a high degree of accuracy by controlling the current value of the high-frequency induction heater. In other words, the amount of melt in the molten pool of semiconductor material can be maintained constant and any variation in the doping agent concentration of the molten pool can be prevented.

Brief Description of the Drawings

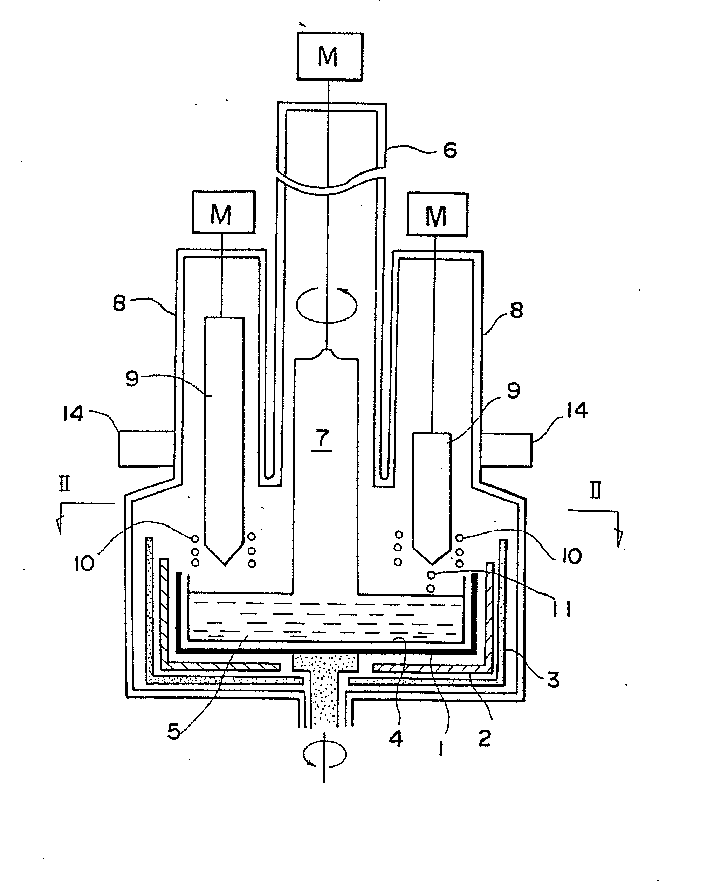

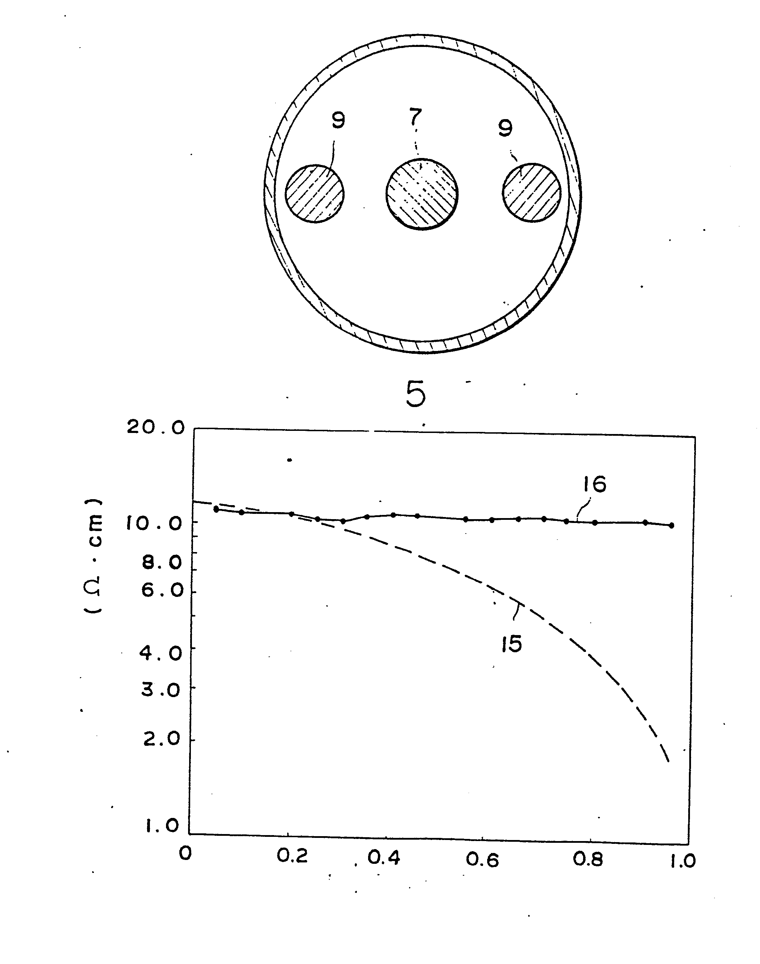

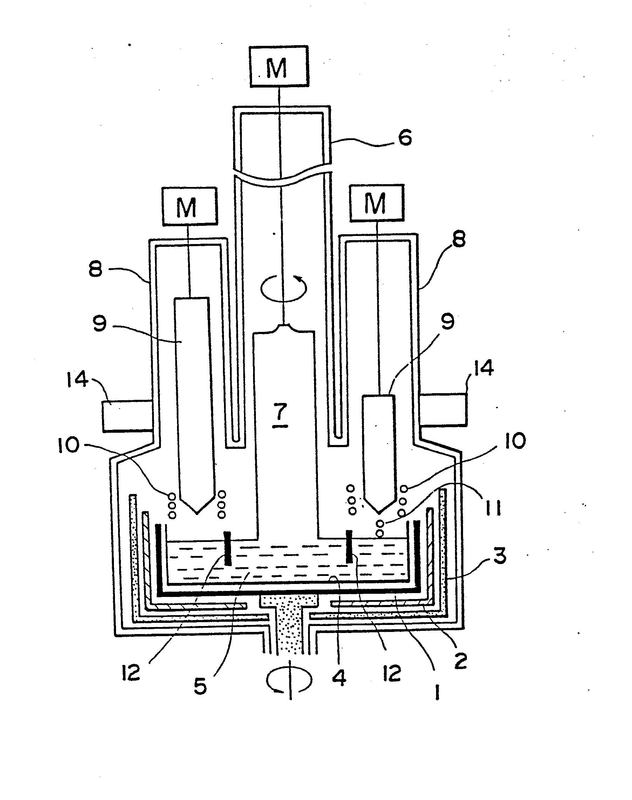

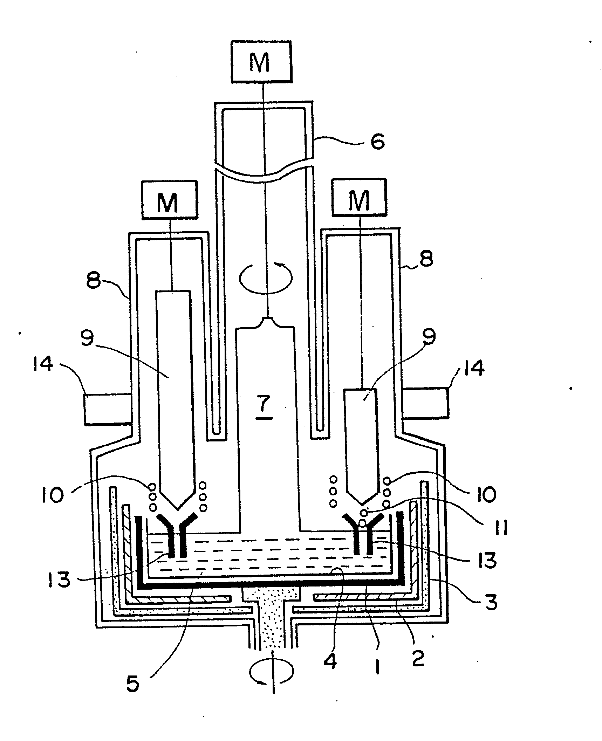

Fig. 1 is an explanatory diagram showing an embodiment of the present invention, Fig. 2 is a view looked in the direction of the arrows II-II of Fig. 1, Figs. 3 and 4 are explanatory diagrams showing another embodiments of the invention, and Fig. 5 is a graph showing the relation between the ratio solidified part and the electrical resistivity.

Best Mode for Carrying Out the Invention

Referring to Fig. 1 illustrating an explanatory diagram showing an embodiment of the invention and Fig. 2 showing a view looked in the direction of the arrows II-II of Fig. 1, numeral (1) designates a carbon crucible, (2) a heater enclosing the carbon crucible, (3) a heat insulating material, (4) a quartz crucible covering the inside of the carbon crucible (1), (5) a molten pool of semiconductor material retained in the quartz crucible, (6) a semiconductor single crystal growing furnace arranged above the molten pool of the semiconductor material, (7) a round shaped semiconductor single crystal bar made by pulling gradually in small amounts from the molten pull and solidifying it, (8) a pair of semiconductor starting material feed furnaces arranged adjacent to the single crystal growing furnace (6), (9) a pair of starting material rods of polycrystal semiconductor suspended in the feed furnaces, and (10) a pair of high-frequency induction heating coils for heating the starting material rods to drip their molten drops (11) to the molten pool (5). It is to be noted that a ring-shaped baffle (12) may be arranged to enclose the single crystal (7) as shown in Fig. 3 or alternatively a funnel-shaped baffle (13) may be arranged just below each starting material rod (9). In these cases, the disturbance in the surface of the molten pool (5) and the variation in the concentration of the doping agent are reduced

very greatly by the baffle (12) or (13). Numeral (14) designates gate valves for isolating the feed furnaces (8) and they are not particularly need if the material is not fed continuously for a long period of time. In addition, the single crystal growing furnace (6) and the feed furnaces (8) need not be separated from each other. Two sets of the high-frequency induction heating coils (10) are equipped with melt control means for controlling the feed rate of the semiconductor melt while melting the starting material rod (9) at a temperature just above the melting point in correspondence to the amount of pull of the single crystal.

In accordance with the invention having the above-described basic construction, it is possible to stably and continuously feed to the molten pool the starting material melted at a temperature which is just above the melting point and which does not disturb the temperature field within the molten pool, thereby maintaining constant the amount of the melt and the doping agent concentration. In other words, it is possible to prevent any variation in quality in the longitudinal and radial directions of the manufactured semiconductor single crystal.

Experimental Example

A starting material rod (9) containing a doping agent and having a diameter of 4 inches was melted into droplets and a single crystal (7) of a semiconductor or silicon having a diameter of 6 inches and a length of 2 meters was grown while feeding the molten droplets (11) into a molten pool (5) (a crucible (4) of 25 inches in diameter). Its procedure was as follows. While maintaining about 30 kg (the depth of 5 cm) of the molten silicon (5) containing the doping agent at a given temperature, in this condiction the forward end of the feed starting material rod (9) was lowered into a high-frequency induction heating coil (10) and the power was supplied to the coil (10) from a high-frequency power source thereby heating the rod (9). With a view to causing a uniform melting loss of the fed starting material rod (9), the rod (9) was rotated at 5 rpm. While the depth of the molten pool (5) should preferably be as small as possible for the purpose of preventing any large convection of heat, in the present experimental example the depth was selected 5 cm in view of the uniformity of the temperature and the uniformity of the doping agent.

While dipping a seed crystal and performing the necking operation, the starting material rod (9) whose preheating was completed was melted and the molten droplets (11) reaching the temperature just above the melting point were slowly dripped into the molten pool (5). Thereafter, the power from the power source was adjusted and the feed rate of the starting material was controlled in such a manner that the melt surface level position always attained the constant level. In this way, the single crystal involving no dislocation was easily pulled.

It is to be noted that when the starting material rod (9) was consumed up to a given amount, the other preliminarily loaded starting material rod (9) was melted and fed. During the interval, the gate valve (14) was closed and the consumed starting material rod (9) was replaced with a new starting material rod. By alterately repeating this operation, it was possible to continuously grow a long single crystal bar. The

other cyrstal growing conditions included the crystal rotation speed of 15 rpm, the crucible rotation speed of 3 rpm in the opposite direction and the crystal pull rate of 0.75 mm/min at the constant diameter portion.

In this experimental example, the melt surface level position was controlled by means of the starting material rod feed rate and therefore no vertical movement of the crucible was required. However, the crucible may be moved vertically for fine adjustments of the melt surface level position. In this case, however, there is the danger of causing the concentration of the doping agent in the molten pool to make small·variations from the steady condition.

In the experimental example, for the purpose of replenishing the starting material rods (9), the two high-frequency induction heating coils (10) were used and the connections of the power source were changed, thereby continuously feeding the molten starting material. However, there will be no essential difference even if a single high-frequency induction heating coil is used and a method of cascade-connecting starting material rods (9) is employed.

Referring now to Fig. 5, there is illustrated the resistivity distribution in the lengthwise direction (corresponding to the ratio of solidified part) of the semiconductor single crystal produced in the present experimental example. As compared with the distribution (15) in the conventional batch type, the resistivity distribution (16) of this invention has a variation of less than 1 % substantially all over the whole length of the crystal. When considering the case of wafers for C-MOS devices, the yield is increased to near to 100 % at a stretch as compared with the conventional yield of about 40 %.

While, in this invention, the high-frequency induction heating coil (10) is used for melting the lower end of the starting material rod (9), any of other melting methods such as a laser, electron beam and direct energization may be used. Also, the pulled single crystal (7) of semiconductor material and the starting material rod (9) are applicable to any other materials than silicon. It is needless to say that the shape of the starting material piece may take the form of a rod, bar, wire or ribbon. Still further, from the standpoint of growing performance and quality of single cyrstal, an equipment for applying a magnetic field to prevent any flowing movement of a silicon melt may be added to the construction of the invention.

CLAIMS

(1) An apparatus for manufacturing semiconductor single crystals of the type in which while rotating a semiconductor material, the semiconductor material is pulled gradually from a molten pool of the semiconductor material melted into a crucible and the semiconductor material is solidified into a round shape bar to produce a semiconductor single crystal bar, characterized in that at least one or more long piece of semiconductor starting material and a high-frequency induction heater for heating said starting material piece are installed in said apparatus.

(2) An apparatus for manufacturing semiconductor single crystals as set forth in claim 1, characterized in that said semiconductor is silicon.

(3) An apparatus for manufacturing semiconductor single crystals as set forth in claim 2, characterized in that said starting material piece is heated and melted while rotating the same.

(4) An apparatus for manufacturing semiconductor single crystals as set forth in claim 2, characterized in that said apparatus comprises a gate valve for closing and isolating said starting material piece.

(5) An apparatus for manufacturing semiconductor single crystals as set forth in claim 1, characterized in that a ring-

0245510

shaped baffle for enclosing said semiconductor single crystals is arranged within said crucible.

2

5

3

FIG. 4

**I. CLASSIFICATION OF SUBJECT MATTER** (if several classification symbols apply, indicate all) [3]

According to International Patent Classification (IPC) or to both National Classification and IPC

Int.Cl$^4$     C30B15/02, 29/06

**II. FIELDS SEARCHED**

| Minimum Documentation Searched [4] | |
|---|---|
| Classification System | Classification Symbols |
| IPC | C30B15/00-15/04, 15/10, 15/12, 29/06 |

| Documentation Searched other than Minimum Documentation to the Extent that such Documents are Included in the Fields Searched [5] |
|---|
| Jitsuyo Shinan Koho                    1955 - 1986 |
| Kokai Jitsuyo Shinan Koho        1971 - 1986 |

**III. DOCUMENTS CONSIDERED TO BE RELEVANT [14]**

| Category* | Citation of Document, [16] with indication, where appropriate, of the relevant passages [17] | Relevant to Claim No [18] |
|---|---|---|
| X | US, A, 3,582,287 (Emil R. Capita) 1 June 1971 (01. 06. 71) | 1, 2 |
| A | JP, B1, 48-6034 (JEOL Ltd.) 22 February 1973 (22. 02. 73) Column 2, lines 24 to 32, Figs. 1, 2 (Family: none) | 3 |
| A | JP, A, 50-55588 (Seidensha Denshi Kogyo Kabushiki Kaisha) 15 May 1975 (15. 05. 75) Page 2, upper right column, line 12 to lower left line 2, Fig. 2 (Family: none) | 4 |
| A | JP, A, 56-88896 (Fujitsu Limited) 18 July 1981 (18. 07. 81) Page 1, right column, line 20 to page 2, upper left column, line 4, Drawing, (Family: none) | 5 |
| A | JP, B2, 59-19913 (Siltec Corporation) 9 May 1984 (09. 05. 84) Column 6, lines 15 to 21, Drawing & US, A, 4,036,595 | 5 |

* Special categories of cited documents: [16]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search [2] | Date of Mailing of this International Search Report [2] |
|---|---|
| December 11, 1986 (11.12.86) | December 22, 1986 (22.12.86) |
| International Searching Authority [1] | Signature of Authorized Officer [20] |
| Japanese Patent Office | |

Form PCT/ISA/210 (second sheet) (October 1981)                    See notes on accompanying sheet